# FASCICULE DE BREVET EUROPEEN

(11) **EP 2 585 840 B1**
(45) Date de publication et mention de la délivrance du brevet: **21.01.2015**
(21) Numéro de dépôt: 11730608.4
(22) Date de dépôt: 22.06.2011
(51) Int. Cl.: G01R 31/28, H01T 15/00, G01R 31/14

(54) **DISPOSITIF DE GENERATION CONTRÔLEE D'ARCS ELECTRIQUES**
VORRICHTUNG FÜR DIE GESTEUERTE ERZEUGUNG VON LICHTBÖGEN
DEVICE FOR THE CONTROLLED GENERATION OF ELECTRIC ARCS

(30) Priorité: 25.06.2010 FR 1055074
(43) Date de publication de la demande: 01.05.2013
(73) Titulaire: Université de Lorraine, 54052 Nancy Cedex (FR)
(72) Inventeur: ANDREA, Jonathan, F-88190 Golbey (FR); SCHWEITZER, Patrick, F-54180 Heillecourt (FR)
(74) Mandataire: Lucas, Laurent Jacques
(86) Numéro de dépôt international: PCT/EP2011/060525
(87) Numéro de publication internationale: WO 2011/161200

(56) Documents cités:
- US-A1- 2004 212 372
- US-A1- 2008 284 450
- WEIYAN ZHENG ET AL: "Detecting low-voltage arc fault based on lifting multiwavelet", COMPUTATIONAL INTELLIGENCE AND INDUSTRIAL APPLICATIONS, 2009. PACIIA 2009. ASIA-PACIFIC CONFERENCE ON, IEEE, PISCATAWAY, NJ, USA, 28 novembre 2009 (2009-11-28), pages 254-257, XP031624111, DOI: DOI:10.1109/PACIIA.2009.5406646 ISBN: 978-1-4244-4606-3

## Description

La présente invention concerne un dispositif de génération contrôlée d'arcs électriques. L'invention s'applique notamment pour effectuer des tests fiables sur des détecteurs d'arcs électriques.

Les défauts d'arc électrique dans les installations électriques, notamment lorsqu'ils se répètent, peuvent causer des dommages importants et même initialiser des incendies. Dans certains domaines la génération d'arcs est particulièrement critique, notamment dans les systèmes embarqués. C'est le cas du domaine aéronautique qui nécessite une très grande vigilance, depuis les systèmes de génération électrique jusqu'aux appareils de pilotage. Il est donc important de pouvoir détecter les arcs électriques dans les installations ou systèmes électriques sensibles et même dans la plupart des systèmes électriques y compris des systèmes domestiques. A cet effet, il faut disposer de détecteurs d'arcs électriques fiables.

Un dispositif qui protège contre les arcs électriques doit être capable de détecter la présence d'un arc et doit être capable d'estimer son niveau de danger en comparaison à des courbes de sécurité connues et mémorisées par ailleurs. Les tests de fonctionnement des détecteurs utilisés doivent notamment :
- permettre de produire quatre types d'arcs électriques ;
- générer un arc calibré reproductible ;
- être en mesure de réguler l'amplitude et la persistance des arcs ;
- permettre de tester différents défauts de coupure de circuits.

En ce qui concerne les quatre types d'arcs électriques générés, on considère généralement une installation électrique standard dans laquelle un générateur électrique principal alimente une charge. Les différents arcs électriques résultant de défaut peuvent être classés en quatre catégories combinant d'un côté les générateurs électriques à tension alternative ou à tension continue et d'un autre côté les configurations d'arcs en série ou en parallèle de la charge.

Il existe des méthodes de génération d'arcs électriques pour tester les détecteurs d'arcs électriques dans le but notamment de tester leur fiabilité, en particulier :
- le test de la guillotine ;
- le test par perte de contact ;

Dans le test de la guillotine, un arc est initialisé par la coupure directe de deux câbles d'alimentation de la charge, l'un conduisant le courant du générateur vers la charge et l'autre depuis la charge vers le générateur. Un court-circuit est alors généré aux bornes de la charge, produisant un arc électrique parallèle. Dans le test par perte de contact, les ouvertures intermittentes de circuit sont causées par des vibrations et les pertes de contact peuvent survenir au niveau des connecteurs. Des arcs en série sont ainsi produits en série avec l'ouverture du circuit.

WEIYAN ZHENG ET AL: "Detecting low-voltage arc fault based on lifting multiwavelet" (COMPUTATIONAL INTELLIGENCE AND INDUSTRIAL APPLICATIONS, 2009. PACIIA 2009. ASIA-PACIFIC CONFERENCE ON, IEEE, PISCATAWAY, NJ, USA, 28 novembre 2009, pages 254-257, ISBN: 978-1-4244-4606-3) décrit un dispositif de génération d'un arc électrique. Un générateur de tension alternative est branché sur la bobine primaire d'un transformateur et l'amorçage de l'arc est créé en déplaçant les électrodes.

Il existe encore d'autres tests. Cependant, tous ces tests connus ne permettent pas de produire des arcs électriques calibrés et reproductibles, conditions pour tester de façon fiable les détecteurs d'arcs.

Un but de l'invention est notamment de pallier cet inconvénient. A cet effet, l'invention a pour objet un dispositif de génération contrôlée d'un arc électrique, comportant au moins :
- un système d'amorçage d'un arc électrique aux bornes de deux électrodes par commutation inductive produisant à sa sortie une surtension aux bornes de ces électrodes ;
- une source d'énergie électrique connectée en série sur la sortie du système d'amorçage, ladite source alimentant l'arc électrique en courant.

Cette source d'énergie électrique est formée par un générateur de tension ou un générateur de courant pour lequel une charge électrique définit la valeur du courant.

Le système d'amorçage comporte par exemple au moins un transformateur, un générateur de tension primaire et un commutateur connectés en série avec la bobine primaire dudit transformateur, la surtension aux bornes des électrodes étant générée aux bornes de la bobine secondaire du transformateur lorsque le commutateur est en position de fermeture, la durée de fermeture du commutateur pouvant être commandable.

Dans un premier mode de réalisation possible, la charge électrique est connectée en série avec le générateur de tension.

Dans un autre mode de réalisation possible, la charge électrique est connectée en parallèle avec le générateur de tension.

La valeur de la charge électrique est par exemple commandable.

La tension en sortie générateur de tension peut être continue ou alternative. Les électrodes sont par exemple placées dans une cuve dans laquelle sont simulées des conditions environnementales.

La cuve comporte par exemple un système de chauffage et de refroidissement commandable.

Le dispositif comporte par exemple une pompe à vide commandable reliée à la cuve pour contrôler la pression à l'intérieur de ladite cuve.

Il comporte par exemple un système pour éloigner ou rapprocher les électrodes les unes des autres, ledit système étant commandable.

D'autres caractéristiques et avantages de l'invention apparaîtront à l'aide de la description qui suit, faite en regard de dessins annexés qui représentent :
- la figure 1, un exemple de réalisation d'un système d'amorçage utilisé dans un dispositif selon l'invention ;
- les figures 2a et 2b, des exemples de commutations ;
- la figure 3, des exemples de surtensions produites au secondaire d'un transformateur en présence d'un arc électrique ;
- la figure 4, un exemple de réalisation d'un dispositif selon l'invention ;
- les figures 5a et 5b, des exemples de configuration de génération d'arc électrique, en série ou en parallèle sur une charge, en mode continu ou alternatif ;
- la figure 6, un exemple de réalisation d'un dispositif selon l'invention permettant notamment de simuler des conditions environnementales.

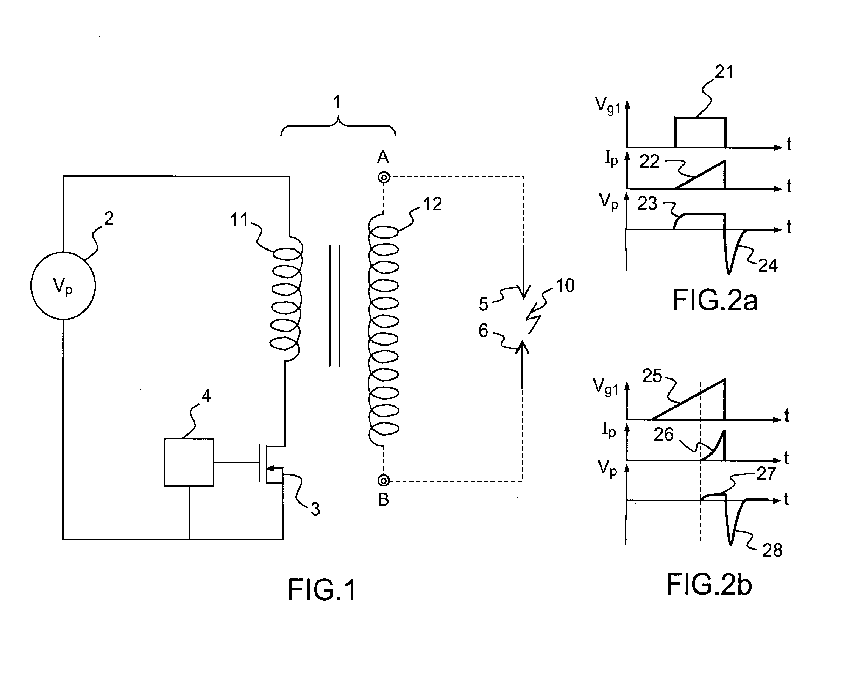

Les figures 1 et 4 et les figures 5a, 5b et 6 illustrent plusieurs modes de réalisation possibles d'un dispositif selon l'invention.

Plus particulièrement, la figure 1 illustre la partie du dispositif qui provoque l'amorçage d'un arc. Dans l'exemple de dispositif illustré par la figure 1, l'amorçage est obtenu par commutation inductive produisant une surtension. Dans le cas de l'exemple de la figure 1, l'inductance commutée est la bobine primaire d'un transformateur 1, la surtension étant produite en sortie de la bobine secondaire du transformateur, le transformateur permettant d'amplifier la surtension produite sur la bobine primaire.

Le dispositif comporte notamment un transformateur élévateur de tension 1 composé d'un enroulement primaire 11 et au moins d'un enroulement secondaire 12, un générateur de tension primaire 2, un commutateur 3 et un système de commande 4 de ce commutateur. L'enroulement primaire 11 est d'une part relié à une borne au générateur de tension 2 et est relié à l'autre borne au commutateur 3. En d'autres termes, cet enroulement primaire est relié aux bornes du générateur 2 via le commutateur 3, la tension aux bornes de cet enroulement étant égale à la tension du générateur lorsque le commutateur est à l'état fermé. Le commutateur 3 est par exemple un transistor de type MOS.

Le principe d'amorçage de l'arc électrique au secondaire du transformateur 1 repose sur l'initialisation d'une surtension. Dans un premier temps, la bobine primaire 11 du transformateur est chargée par le courant fourni par le générateur de tension primaire 2. Le transistor 3 conduit progressivement le courant passant dans la bobine primaire 11 jusqu'à atteindre sa valeur de courant maximale acceptable. Puis le transistor agissant en interrupteur, coupe rapidement le circuit faisant passer le courant de la valeur maximale à un courant de valeur nulle. Cette coupure rapide entraîne l'apparition d'une haute tension Vₚ aux bornes de la bobine primaire 11 définie classiquement par la relation Vₚ = Lp dlₚ/dt, où Lp est l'inductance la bobine primaire, dlₚ la variation de courant dans cette bobine, entre la valeur maximale et la valeur nulle et dt étant la durée de commutation d'une valeur à l'autre. Cette haute tension est d'autant plus importante que l'inductance Lp est grande et que le temps de commutation dt est faible. Si le transformateur est élévateur comme dans l'exemple de la figure 1, la haute tension produite aux bornes de la bobine primaire se retrouve amplifiée aux bornes de la bobine secondaire. Le rapport de transformation entre l'enroulement secondaire et l'enroulement primaire est par exemple de l'ordre de 100. Le transistor 3 placé au primaire du transformateur est par exemple dimensionné pour conduire un courant pouvant atteindre 20 A, le générateur primaire 2 délivrant par exemple une tension nominale continue de 65 V et un courant nominal de 50 A.

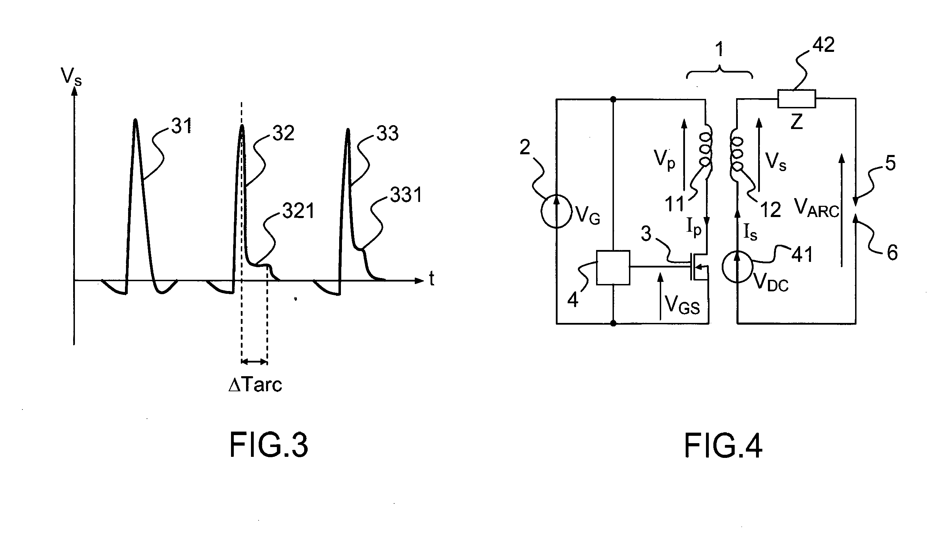

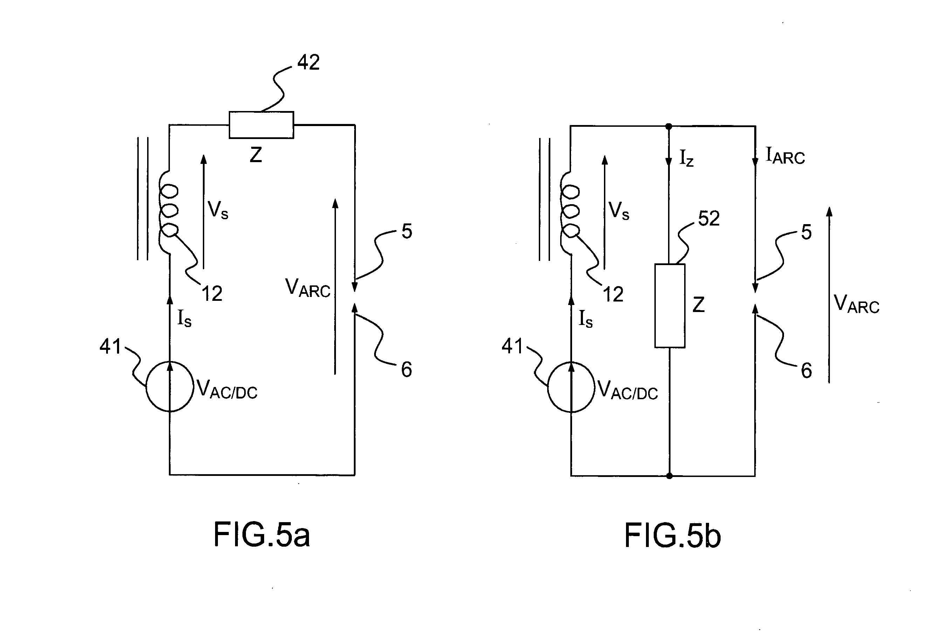

Dans le mode d'illustration de la figure 1, le circuit au secondaire du transformateur 1, plus particulièrement entre les bornes A, B, de la bobine secondaire 12, est représenté de manière simplifiée. Seules les électrodes en présence 5, 6 susceptibles de provoquer un arc électrique sont représentées. Les différents modes de réalisation du circuit secondaire d'un dispositif selon l'invention sont notamment représentés par la figure 4 et les figures 5a et 5b.

Un arc 10 apparaît entre les électrodes 5, 6 lorsque la tension de claquage du diélectrique ambiant entre ces électrodes est atteinte. Cette tension est de l'ordre de 30 kV/cm dans l'air. La tension de claquage dépend principalement de la distance séparant les deux électrodes 5, 6 et de la rigidité du diélectrique. Lorsque les électrodes sont dans l'air, les conditions atmosphériques telles que la température, la pression ou l'hygrométrie sont également des facteurs d'influence. Il en est de même pour la géométrie et le matériau constitutif des électrodes.

Les figures 2a et 2b illustrent deux modes de commandes possibles du transistor 3 commutant le courant dans la bobine primaire 11. La commande est appliquée par le système de commande 4 dont la réalisation est connue de l'homme du métier. Les figures 2a et 2b illustrent les modes, de commande par la tension appliquée entre la grille et la source du transistor 3 en fonction du temps.

Dans le premier mode illustré par la figure 2a, le transistor est commandé par une tension grille-source V_{gs} d'allure carrée 21. Le transistor agit comme un commutateur. Quand il est à l'état fermé, le courant Iₚ dans la bobine primaire 11 croît linéairement jusqu'à la valeur maximale puis chute brutalement à la valeur zéro, évoluant ainsi selon une rampe 22. Pendant la charge de la bobine primaire 11, c'est-à-dire pendant la rampe 22, la tension aux bornes de la bobine primaire vₚ se stabilise rapidement à la valeur de tension Vₚ produite aux bornes du générateur. Puis la commutation provoque une pointe de surtension inverse 24, toujours aux bornes de la bobine primaire 11.

Dans le deuxième mode, illustré par la figure 2b, l'énergie globale dépensée est diminuée. Dans ce mode, la tension de commande grille-source V_{gs} n'est plus de forme carrée mais a la forme d'une rampe 25. Le courant dans la bobine primaire se met à circuler plus tardivement pour croître 26 jusqu'à la valeur maximale. La tension aux bornes de l'enroulement primaire reste faible 27 pendant la charge de la bobine. Enfin, la pointe de tension inverse 28 dépendant de la valeur de courant maximale atteinte est la même que celle obtenu dans le premier mode. L'énergie électrique globale dépensée est nettement moins importante que dans le premier mode comme l'indique la comparaison des produits des surfaces de tension et de courant entre les figures 2a et 2b.

La figure 3 illustre trois cas possibles de surtensions aux bornes de la bobine secondaire 12, les courbes représentant l'allure de la tension Vs aux bornes de la bobine secondaire en fonction du temps. La bobine secondaire est par exemple câblée de façon à être inversée par rapport à la tension primaire.

Une première courbe 31 correspond à un cas sans production d'arc.

Une deuxième courbe 32 présente un cas avec un arc. Comme dans le cas précédent 31, une surtension est produite lorsque la tension de claquage est atteinte puis la tension chute et se stabilise à une valeur donnée 321 pendant la durée de l'arc électrique (Δ Tarc), cette tension stabilisée caractérisant l'intensité de l'arc électrique. Enfin, l'arc disparaît et la tension chute à zéro. Une troisième courbe 33 représente toujours un cas avec production d'arc mais où la distance entre les électrodes a augmenté de sorte que la durée de l'arc électrique a diminué, la valeur stabilisée 331 de tension secondaire étant plus courte que la précédente 321.

Dans les dispositifs de génération d'arcs électrique selon l'art antérieur, l'intensité et la durée de l'arc n'est pas contrôlable, c'est-à-dire en particulier qu'elle ne peut pas être calibrée en intensité et en durée, et cela de façon répétitive.

La figure 4 présente un exemple de réalisation d'un dispositif selon l'invention. La partie primaire du dispositif, ayant notamment pour fonction d'amorcer l'arc électrique, est la même que celle présentée par la figure 1. Un générateur 2 fournit une tension V_{G} à la bobine primaire qui se charge avec un courant Iₚ commandé par le commutateur 3, un transistor de type MOS dans cet exemple. Comme indiqué précédemment la coupure du courant primaire Iₚ provoque une surtension aux bornes de la bobine secondaire 12 amorçant un arc comme représenté par les courbes 32, 33 de la figure 3.

La bobine secondaire 12 est reliée en série à une charge 42 elle-même en série avec les électrodes 5, 6 aux bornes desquelles un arc électrique est susceptible de se reproduire. Sur la figure 4, les électrodes 5, 6 symbolisent un défaut électrique susceptible de se produire, par exemple une coupure de câble ou encore une perte de contact, ces défaut étant produits en phase de test. La charge 42 en série représente un cas d'application où le défaut se produit en série sur une charge électrique elle-même en série avec le générateur, c'est le cas notamment d'un défaut par perte de contact, par exemple au niveau d'un connecteur.

L'amorçage de l'arc est suivi par un chute de tension qui se stabilise à une valeur donnée comme l'illustre les courbes 32 et 33 de la figure 3. Selon l'invention, une source d'énergie électrique, par exemple de courant, est placée en série avec la bobine secondaire 12 et l'endroit du circuit où se produit l'arc électrique, c'est-à-dire les électrodes 5, 6 sur la figure 4.

Dans l'exemple de la figure 4, la source de courant est formée à partir d'un générateur de tension 41, la tension étant par exemple continue. Le courant est défini par la tension aux bornes du générateur et les charges électriques connectées en série avec ce dernier.

Avantageusement, ce générateur 41 permet d'entretenir un courant dans l'arc électrique et donc de maintenir ce dernier. En jouant notamment sur l'intensité du courant et sur sa durée, on peut calibrer l'intensité et la durée de l'arc et lui donner par ailleurs un caractère répétitif. En pratique, on peut jouer sur la tension de sortie du générateur qui définit elle-même l'intensité du courant en fonction de la charge. L'exemple de la figure 4 représente un cas d'arc électrique dans un système électrique alimenté par une tension continue, l'arc se produisant en série avec la charge électrique. D'autres types de générateurs peuvent être utilisés comme le montrent les figures 5a et 5b.

Les figures 5a et 5b illustrent quatre types de circuits possibles au secondaire d'un dispositif selon l'invention. Ces différents câblages permettent de tester les quatre cas suivant :
- système alimenté par une tension continue avec un arc en série sur la charge électrique ;
- système alimenté par une tension alternative avec un arc en série sur la charge électrique ;
- système alimenté par une tension continue avec un arc en parallèle sur la charge électrique ;
- système alimenté par une tension alternative avec un arc en parallèle sur la charge électrique.

Le câblage de la figure 5a permet de tester les deux premiers cas, le générateur 41 étant soit à tension continue, soit à tension alternative et la charge 42 étant en série avec l'arc électrique qui se produit au niveau des électrodes 5, 6.

Le câblage de la figure 5b permet de tester les deux derniers cas, le générateur 41 étant soit à tension continue, soit à tension alternative et la charge 52 étant en parallèle avec l'arc électrique.

Un principe de fonctionnement d'un dispositif selon l'invention est donc le suivant. La partie primaire du transformateur 1 amorce l'arc électrique et la partie secondaire entretien de façon contrôlée cet arc électrique.

Ainsi, le générateur 2 au primaire fournit un courant de charge à la bobine primaire 11, ce courant de charge étant coupé par le commutateur 3. Une surtension se produit alors aux bornes de la bobine 12 du transformateur. L'enroulement de la bobine secondaire est calculé pour amplifier la tension primaire afin d'atteindre notamment la tension de claquage souhaitée.

Au secondaire, une fois le commutateur en position ouverte, le générateur 41 prend le relai pour maintenir l'arc. La valeur de la tension et sa durée permettent de contrôler l'arc à l'intensité et à la durée souhaitée.

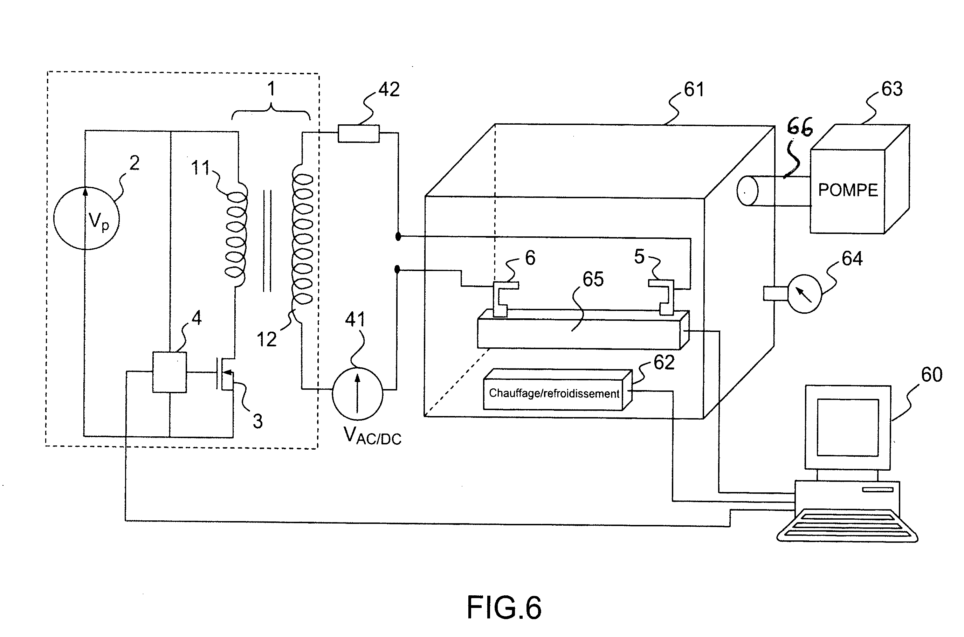

La figure 6 illustre un exemple de réalisation d'un générateur d'arcs électriques selon l'invention permettant de paramétrer les conditions environnementales de l'arc électrique.

Dans cet exemple la charge électrique 42 est en série avec les électrodes 5, 6 aux bornes desquelles se produit l'arc électrique. Un générateur 41 de tension continue ou alternative est connecté en série avec la charge et les électrodes 5, 6 comme dans l'exemple de la figure 5a.

Les électrodes 5, 6 sont placées dans une cuve 61 à l'intérieur de laquelle il est possible de paramétrer des conditions environnementales. Dans cet exemple, il est possible de reproduire des conditions de température et des conditions de pression. Il serait possible d'envisager de reproduire aussi des conditions hygrométriques par exemple.

Un dispositif de chauffage et de refroidissement 62 placé à l'intérieur de la cuve 61 permet de fixer une température donnée à l'intérieur de cette cuve. Cette dernière est par ailleurs reliée par un tuyau 66 à une pompe à vide 63 permettant de fixer une pression donnée à l'intérieur, un baromètre 64 permet de vérifier la pression interne. La gamme de température est par exemple comprise entre -10° et 50° Celsius tandis que la gamme de pression est par exemple comprise entre 0,2 bar et 1 bar, d'autres gammes pouvant bien sûr être appliquées.

En plus du paramétrage des conditions environnementales, le dispositif de la figure 6 permet de paramétrer la distance entre les électrodes 5, 6. A cet effet, les électrodes 5, 6 sont montées sur un système 65 qui commande leur déplacement, par exemple un système à vis sans fin qui entraîne le déplacement d'un plateau. Le déplacement est alors commandé par la rotation de la vis, elle-même commandée par un dispositif adapté. Ce système 65 permet d'approcher ou d'éloigner les électrodes 5, 6 les unes des autres.

Le réglage du temps d'installation d'arc est par exemple réglé automatiquement par l'intermédiaire du circuit de commande 4 assurant l'ouverture ou la fermeture du commutateur 3 au primaire du transformateur 1. Lorsque le commutateur 3 est en position de fermeture, le secondaire du transformateur fonctionne en générateur de surtension et amorce un arc électrique entre les électrodes 5, 6. Lorsque l'interrupteur 3 est ouvert, le générateur au niveau secondaire n'alimente plus la charge, le relai étant pris par le générateur de tension 41 qui par la-même entretient l'arc électrique. L'intensité du courant dans le circuit secondaire, et donc dans l'arc électrique, dépend de la valeur de la charge 42 montée en série. Le réglage du courant peut donc se faire en jouant sur cette valeur de charge. A cet effet, il est possible de prévoir une charge variable et commandable, plus particulièrement la valeur de la résistance de charge étant commandable. La partie complexe de la charge, composante inductive et capacitive, peut aussi être commandée.

Les différents paramétrages du circuit, en particulier l'intensité du courant dans l'arc électrique, la durée d'amorçage de cet arc électrique, les conditions de température et de pression sont par exemple commandable à partir d'un ordinateur 60 relié, aux moyens d'interfaces adaptés, aux organes de commandes de la charge 42, du commutateur 3, du système de chauffage et de refroidissement 62 et de la pompe 63. Plusieurs programmes de commandes peuvent ainsi être mis en oeuvre automatiquement par l'ordinateur 60.

Un dispositif selon l'invention permet de produire de façon contrôlée en intensité et en durée des arcs en série et en parallèle, en mode continu ou alternatif. Selon la configuration choisie, le défaut d'arc peut être créé systématiquement à chaque surtension et le générateur secondaire 41 fournit la puissance qui permet de maintenir l'arc électrique, en série ou en parallèle d'une charge. Différents types de charges, parmi lesquelles des disjoncteurs particuliers, peuvent être utilisées afin d'observer le comportement du défaut d'arc dans un circuit complexe.

L'invention permet avantageusement de tester tous types d'appareils et de systèmes de disjonctions d'arcs.

## Revendications

1. Dispositif de génération contrôlée d'un arc électrique, **caractérisé en ce qu'**il comporte au moins :
- un système d'amorçage d'un arc électrique (3, 4, 11, 12) aux bornes de deux électrodes (5, 6) par commutation inductive produisant à sa sortie (A, B) une surtension aux bornes de ces électrodes (5, 6) ;
- une source d'énergie électrique (41, 42, 52) connectée en série sur la sortie (A, B) du système d'amorçage, ladite source alimentant l'arc électrique en courant.

2. Dispositif selon la revendication 1, **caractérisé en ce que** la source d'énergie électrique est un générateur de tension (41), une charge électrique (42, 52) définissant la valeur du courant.

3. Dispositif selon la revendication 1, **caractérisé en ce que** la source d'énergie électrique est un générateur de courant, une charge électrique (41) définissant la valeur du courant.

4. Dispositif selon l'une quelconque des revendications précédentes, **caractérisé en ce que** le système d'amorçage comporte au moins un transformateur (1), un générateur de tension primaire (2) et un commutateur (3) connectés en série avec la bobine primaire (11) dudit transformateur (1), la surtension aux bornes des électrodes (5, 6) étant générée aux bornes (A, B) de la bobine secondaire (12) du transformateur lorsque le commutateur (3) est en position de fermeture.

5. Dispositif selon la revendication 4, **caractérisé en ce que** la durée de fermeture du commutateur (3) est commandable (4).

6. Dispositif selon l'une quelconque des revendications précédentes, **caractérisé en ce que** la charge électrique (42) est connectée en série avec la source d'énergie électrique (41).

7. Dispositif selon l'une quelconque des revendications 1 à 5, **caractérisé en ce que** la charge électrique (52) est connectée en parallèle avec la source d'énergie électrique (41).

8. Dispositif selon l'une quelconque des revendications 6 ou 7, **caractérisé en ce que** la valeur de la charge électrique (42, 52) est commandable.

9. Dispositif selon l'une quelconque des revendications 2 à 8, **caractérisé en ce que** la tension en sortie du générateur de tension (41) est continue.

10. Dispositif selon l'une quelconque des revendications 2 à 8, **caractérisé en ce que** la tension en sortie du générateur de tension (41) est alternative.

11. Dispositif selon l'une quelconque des revendications précédentes, **caractérisé en ce que** les électrodes (5, 6) sont placées dans une cuve (61) dans laquelle sont simulées des conditions environnementales.

12. Dispositif selon la revendication 11, **caractérisé en ce que** la cuve (61) comporte un système de chauffage et de refroidissement (62) commandable.

13. Dispositif selon l'une quelconque des revendications 11 ou 12, **caractérisé en ce qu'**il comporte une pompe à vide (63) commandable reliée à la cuve (61) pour contrôler la pression à l'intérieur de ladite cuve.

14. Dispositif selon l'une quelconque des revendications précédentes, caractérisé qu'il comporte un système (65) pour éloigner ou rapprocher les électrodes (5, 6) les unes des autres, ledit système étant commandable.

## Patentansprüche

1. Vorrichtung zum gesteuerten Erzeugen eines Lichtbogens, **dadurch gekennzeichnet, dass** sie wenigstens Folgendes umfasst:
- ein System zum Zünden eines Lichtbogens (3, 4, 11, 12) an den Anschlüssen von zwei Elektroden (5, 6) durch induktive Schaltung, das an seinem Ausgang (A, B) eine Überspannung zu den Anschlüssen dieser Elektroden (5, 6) produziert;
- eine elektrische Energiequelle (41, 42, 52), die in Serie mit dem Ausgang (A, B) des Zündsystems geschaltet ist, wobei die Quelle den Lichtbogen mit Strom versorgt.

2. Vorrichtung nach Anspruch 1, **dadurch gekennzeichnet, dass** die elektrische Energiequelle ein Spannungsgenerator (41) ist, wobei eine elektrische Ladung (42, 52) den Wert des Stroms definiert.

3. Vorrichtung nach Anspruch 1, **dadurch gekennzeichnet, dass** die elektrische Energiequelle ein Stromgenerator ist, wobei eine elektrische Ladung (41) den Wert des Stroms definiert.

4. Vorrichtung nach einem der vorherigen Ansprüche, **dadurch gekennzeichnet, dass** das Zündsystem wenigstens einen Transformator (1), einen Primärspannungsgenerator (2) und einen Schalter (3) umfasst, die in Serie mit der Primärwicklung (11) des Transformators (1) geschaltet sind, wobei die Überspannung zu den Anschlüssen der Elektroden (5, 6) an den Anschlüssen (A, B) der Sekundärwicklung (12) des Transformators erzeugt wird, wenn der Schalter (3) in einer geschlossenen Position ist.

5. Vorrichtung nach Anspruch 4, **dadurch gekennzeichnet, dass** die Schließdauer des Schalters (3) regelbar ist (4).

6. Vorrichtung nach einem der vorherigen Ansprüche, **dadurch gekennzeichnet, dass** die elektrische Ladung (42) in Serie mit der elektrischen Energiequelle (41) geschaltet ist.

7. Vorrichtung nach einem der Ansprüche 1 bis 5, **dadurch gekennzeichnet, dass** die elektrische Ladung (52) parallel mit der elektrischen Energiequelle (41) geschaltet ist.

8. Vorrichtung nach Anspruch 6 oder 7, **dadurch gekennzeichnet, dass** der Wert der elektrischen Ladung (42, 52) regelbar ist.

9. Vorrichtung nach einem der Ansprüche 2 bis 8, **dadurch gekennzeichnet, dass** die Spannung am Ausgang des Spannungsgenerators (41) Gleichspannung ist.

10. Vorrichtung nach einem der Ansprüche 2 bis 8, **dadurch gekennzeichnet, dass** die Spannung am Ausgang des Spannungsgenerators (41) Wechselspannung ist.

11. Vorrichtung nach einem der vorherigen Ansprüche, **dadurch gekennzeichnet, dass** die Elektroden (5, 6) in einem Behälter (61) platziert sind, in dem Umweltbedingungen simuliert werden.

12. Vorrichtung nach Anspruch 11, **dadurch gekennzeichnet, dass** der Behälter (61) ein steuerbares Heiz- und Kühlsystem (62) umfasst.

13. Vorrichtung nach Anspruch 11 oder 12, **dadurch gekennzeichnet, dass** sie eine steuerbare Vakuumpumpe (63) umfasst, die mit dem Behälter (61) zum Regeln des Drucks im Innern des Behälters verbunden ist.

14. Vorrichtung nach einem der vorherigen Ansprüche, **dadurch gekennzeichnet, dass** sie ein System (65) zum Vergößern oder Verkleinern des Abstands der Elektroden (5, 6) voneinander umfasst, wobei das System steuerbar ist.

## Claims

1. A device for the controlled generation of an electric arc, **characterized in that** it comprises at least:
- a system for striking an electric arc (3, 4, 11, 12) on the terminals of two electrodes (5, 6) through inductive switching, producing at its output (A, B) an overvoltage on the terminals of these electrodes (5, 6);
- an electrical power source (41, 42, 52) connected in series to the output (A, B) of the striking system, said source supplying the electric arc with current.

2. The device as claimed in claim 1, **characterized in that** the electrical power source is a voltage generator (41), an electric load (42, 52) defining the value of the current.

3. The device as claimed in claim 1, **characterized in that** the electrical power source is a current generator, an electric load (41) defining the value of the current.

4. The device as claimed in any one of the preceding claims, **characterized in that** the striking system comprises at least a transformer (1), a primary voltage generator (2) and a switch (3) connected in series with the primary coil (11) of said transformer (1), the overvoltage on the terminals of the electrodes (5, 6) being generated on the terminals (A, B) of the secondary coil (12) of the transformer when the switch (3) is in the closed position.

5. The device as claimed in claim 4, **characterized in that** the duration of closure of the switch (3) is controllable (4).

6. The device as claimed in any one of the preceding claims, **characterized in that** the electric load (42) is connected in series with the electrical power source (41).

7. The device as claimed in any one of claims 1 to 5, **characterized in that** the electric load (52) is connected in parallel with the electrical power source (41).

8. The device as claimed in any one of claims 6 or 7, **characterized in that** the value of the electric load (42, 52) is controllable.

9. The device as claimed in any one of claims 2 to 8, **characterized in that** the voltage at the output of the voltage generator (41) is direct.

10. The device as claimed in any one of claims 2 to 8, **characterized in that** the voltage at the output of the voltage generator (41) is alternating.

11. The device as claimed in any one of the preceding claims, **characterized in that** the electrodes (5, 6) are placed in a container (61) in which environmental conditions are simulated.

12. The device as claimed in claim 11, **characterized in that** the container (61) comprises a controllable heating and cooling system (62).

13. The device as claimed in any one of claims 11 or 12, **characterized in that** it comprises a controllable vacuum pump (63) connected to the container (61) to control the pressure inside said container.

14. The device as claimed in any one of the preceding claims, **characterized in that** it comprises a system (65) to move the electrodes (5, 6) away from or towards one another, said system being controllable.
